# EUROPEAN PATENT SPECIFICATION

(11) **EP 4 199 676 B1**
(45) Date of publication and mention of the grant of the patent: **30.04.2025**
(21) Application number: 22865871.2
(22) Date of filing: 26.08.2022
(51) Int. Cl.: H05K 7/20, H01L 23/427, H01L 23/36, H05K 1/02, H01L 23/42, H01L 23/433, H01L 23/367, H01L 23/373

(54) **HEAT CONDUCTION PAD, HEAT DISSIPATION MODULE AND ELECTRONIC DEVICE**
WÄRMELEITPAD, WÄRMEABLEITUNGSMODUL UND ELEKTRONISCHE VORRICHTUNG
TAMPON DE CONDUCTION THERMIQUE, MODULE DE DISSIPATION THERMIQUE ET DISPOSITIF ÉLECTRONIQUE

(30) Priority: 27.10.2021 CN 202111260485
(43) Date of publication of application: 21.06.2023
(73) Proprietor: Honor Device Co., Ltd., Shenzhen, Guangdong 518040 (CN)
(72) Inventor: LI, Erliang, Shenzhen, Guangdong 518040 (CN); DONG, Hanghang, Shenzhen, Guangdong 518040 (CN); YANG, Junjie, Shenzhen, Guangdong 518040 (CN)
(74) Representative: Isarpatent
(86) International application number: PCT/CN2022/115225
(87) International publication number: WO 2023/071485

(56) References cited:
- CN-A- 112 713 128
- CN-A- 113 517 243
- CN-U- 207 051 829
- CN-U- 207 382 767
- CN-U- 207 382 767
- CN-U- 211 531 648
- US-A1- 2006 028 799

## Description

Priority is claimed to Chinese Patent Application No. 202111260485.4, filed with the China National Intellectual Property Administration on October 27, 2021 and entitled "THERMAL PAD, HEAT DISSIPATION MODULE, AND ELECTRONIC DEVICE".

### TECHNICAL FIELD

This disclosure generally relates to the field of thermal pad technologies, and the invention in particular relates to a thermal pad, a heat dissipation module, and an electronic device.

### BACKGROUND

As an electronic device rapidly develops towards miniaturization and high performance, a heat dissipation requirement of an electronic component located in a small space inside the device becomes more and more urgent. Therefore, how to arrange heat dissipation of the electronic component becomes one of the important topics in the industry.

In a conventional electronic device, a thermal pad is usually disposed between an electronic component and a heat sink, and the thermal pad is usually made of a material such as thermally conductive silicone or thermally conductive silicone rubber, to transfer heat generated by the electronic component to the heat sink for dissipation. However, due to a limitation of heat conduction efficiency of a material of the thermal pad, heat conduction efficiency of the foregoing thermal pad is not high, and cannot meet a heat dissipation requirement of the electronic component, especially the heat dissipation requirement of a high-power electronic component.

To improve heat dissipation efficiency of the electronic component, in an electronic device in a related technology, a liquid metal layer (whose material is a liquid metal material) is disposed between the electronic component and the heat sink. To prevent the liquid metal layer from spilling between the electronic component and the heat sink, a sealing ring needs to be disposed between the electronic component and the heat sink. However, after a sealing ring is disposed, a structure of the heat dissipation module is more complex, and then a difficulty of assembly process of the heat dissipation module is increased, which increases manufacturing costs of the heat dissipation module.

US 2006/028799 A1 discloses that in a method for manufacturing of an electronic component device, an electronic component and a heat dissipating member are connected through a heat conducting member. The document further discloses steps of forming one of a plate shape metallic member and a recessed metallic member on the electronic component by vapor deposition processing or plating processing, forming the other of the plate shape metallic member and the recessed metallic member on the heat dissipating member by the vapor deposition processing or the plating processing, and filling a liquid metal in the recessed part of the recessed metallic member to form the liquid metal, the plate shape metallic member, and a part of the recessed metallic member into a solid solution.

CN 207382767 U addresses the technical problems of the inefficiency and safety issues associated with traditional heat dissipation materials and methods used in smartphones. Specifically, the problems include inefficient thermal management, leakage of liquid metal and suboptimal sealing solutions. A heat dissipation structure for mobile phones is disclosed that uses liquid metal material. The design effectively prevents the liquid metal from overflowing after phase change while maximizing heat dissipation and minimizing leakage.

CN 112713128 A discloses an intelligent controller heat dissipation method and device, and the method comprises the following steps: after a chip is used and generates heat, the heat is transmitted to a heat conduction copper block through liquid metal with a high heat conduction coefficient; a copper block and an aluminum radiating fin are rolled together, and the copper block is in direct contact with liquid metal; by means of the good heat absorption performance of copper, heat is rapidly transmitted to the copper block, the copper block and the aluminum cooling fin are rolled together, the contact area is large, heat on the copper block is rapidly transmitted to the aluminum cooling fin, and by means of the excellent heat dissipation performance of aluminum, heat is rapidly dissipated; and the heat can be transferred to a radiator on the outer side of the aluminum radiating fin again.

### SUMMARY

The object of the present invention is to provide a thermal pad, a heat dissipation module, and an electronic device, so as to resolve a problem that the heat dissipation module of the electronic device in a related technology cannot simultaneously improve heat dissipation efficiency and reduce manufacturing costs. This object is solved by the attached independent claims and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the invention or its embodiments, which, however, is not claimed as such.

To achieve the foregoing objective, the following technical solutions according to the invention are used in embodiments of this application.

According to a first aspect according to the invention, the invention provides a thermal pad, including a pad body, where the pad body is provided with a hollowed-out part, and the hollowed-out part is filled with a liquid metal material layer.

By using the technical solution, an overall coefficient of thermal conductivity of the thermal pad is improved, overall thermal resistance of the thermal pad is reduced, and heat dissipation efficiency of an electronic component is improved, so that heat dissipation of the electronic component is more sufficient. In addition, there is no need to dispose another sealing structure to limit the flow of the liquid metal material layer, so that not only a structure of the heat dissipation module is simpler, but also assembly process of the heat dissipation module is simplified, which thereby reducing manufacturing costs of the heat dissipation module.

According to the invention, in a thickness direction of the pad body, the pad body includes two pad surfaces that are disposed facing away from each other, and the hollowed-out part is disposed on the pad surface.

By using the technical solution, overall thermal resistance of the thermal pad can be greatly reduced.

According to the invention, the hollowed-out part penetrates through the pad body.

By using the technical solution, liquid metal material layers in the hollowed-out parts may be separately in contact with the electronic component and the heat sink, thereby further reducing the overall thermal resistance of the thermal pad.

According to the invention, each pad surface is provided with the hollowed-out part, and a depth of the hollowed-out part is less than a thickness of the pad body.

By using the technical solution, the liquid metal material layers in the hollowed-out parts of the two pad surfaces may be separately in contact with the electronic component and the heat sink, thereby further reducing the overall thermal resistance of the thermal pad.

In some embodiments, the hollowed-out parts disposed on the two pad surfaces are staggered in a direction perpendicular to the thickness direction of the pad body.

By using the technical solution, when a total quantity of hollowed-out parts is specified, a coverage area of the liquid metal material layer in the pad body is increased, which further improves a heat dissipation effect of the electronic component.

In some not claimed embodiments, the pad surface is provided with a plurality of hollowed-out parts arranged in an array.

By using the technical solution, a coverage area of the liquid metal material layer in the pad body is increased, which further improves the heat dissipation effect of the electronic component.

In some not claimed embodiments, the hollowed-out part is a hole or a groove.

By using the technical solution, manufacturing of the hollowed-out part may be facilitated.

In some embodiments, the pad surface includes a hollowed-out opening area and a surrounding area that is located on a periphery of the hollowed-out opening area; and the hollowed-out opening area is provided with the hollowed-out part, and the surrounding area is provided with an anti-spill groove.

By using the technical solution, diffusion of the liquid metal material may be prevented, thereby reducing a probability that the liquid metal material leaks out of an edge of the thermal pad.

In some embodiments, the anti-spill groove is separated from the hollowed-out part.

By using the technical solution, when the liquid metal material is filled into the hollowed-out part, a probability that the liquid metal material in the hollowed-out part enters the anti-spill groove can be reduced.

In some embodiments, the anti-spill groove extends in a circumferential direction of the hollowed-out opening area.

By using the technical solution, an effect of preventing diffusion of the spilled liquid metal material to a surrounding area by the anti-spill groove is improved.

In some embodiments, the surrounding area is provided with an anti-spill groove group, and the anti-spill groove group includes a plurality of anti-spill grooves disposed around the hollowed-out opening area.

By using the technical solution, the diffusion of the spilled liquid metal material in a plurality of directions can be prevented, thereby further reducing a probability that the liquid metal material leaks out of the edge of the thermal pad.

In some embodiments, the surrounding area is provided with the plurality of anti-spill groove groups, and the plurality of anti-spill groove groups are arranged in a direction away from the hollowed-out opening area.

By using the technical solution, the diffusion of the spilled liquid metal material in a plurality of directions can be better prevented, thereby greatly reducing the probability that the liquid metal material leaks out of the edge of the thermal pad.

In some embodiments, each anti-spill groove in the anti-spill groove groups penetrates through the pad body.

By using the technical solution, a volume of the anti-spill groove can be increased, so that the liquid metal material can be better prevented from continuing to diffuse outward.

In some embodiments, the anti-spill groove is a ring groove and is disposed around the hollowed-out opening area, and a groove depth of the anti-spill groove is less than the thickness of the pad body.

By using the technical solution, the diffusion of the spilled liquid metal material in a plurality of directions can be better prevented, thereby reducing the probability that the liquid metal material leaks out of the edge of the thermal pad.

In some embodiments, the surrounding area is provided with the plurality of anti-spill grooves, and the plurality of anti-spill grooves are arranged in a direction away from the hollowed-out opening area.

By using the technical solution, the plurality of anti-spill grooves can better prevent the diffusion of the spilled liquid metal material in a plurality of directions, thereby greatly reducing the probability that the liquid metal material leaks out of the edge of the thermal pad.

In some embodiments, one end of the anti-spill groove extends to an edge of the hollowed-out part, to communicate with the hollowed-out part.

By using the technical solution, a probability that the liquid metal material spills from an edge of the hollowed-out part can be greatly reduced.

In some not claimed embodiments, a width range of the anti-spill groove is 0.1~0.2 mm.

By using the technical solution, the liquid metal material filled into the hollowed-out part will not easily enter the anti-spill groove, or an accommodating space of the anti-spill groove will not be too small, thereby ensuring that the anti-spill groove can better prevent spilling of the liquid metal material.

In some embodiments, the hollowed-out opening area is provided with two rows of the hollowed-out parts, each row includes a plurality of hollowed-out parts, and each hollowed-out part separately communicates with at least one anti-spill groove.

By using the technical solution, the anti-spill groove may easily communicate with each hollowed-out part.

In some not claimed embodiments, the thermal pad further includes a protective film, and the protective film is attached to the pad surface, to cover the liquid metal material layer.

By using the technical solution, leakage of the liquid metal material in the hollowed-out part may be prevented, thereby facilitating storage and transportation of the thermal pad.

According to a second aspect according to the invention, the invention also provides a heat dissipation module, including an electronic component, a heat sink, and the thermal pad in the first aspect, where a pad body of the thermal pad is disposed between the electronic component and the heat sink.

A beneficial effect of the heat dissipation module is the same as that of the thermal pad in the first aspect, and details are not described herein again.

In some embodiments, the electronic component is a central processing unit; and the central processing unit includes a substrate and a bare die disposed on the substrate, and the pad body is disposed between the bare die and the heat sink.

By using the technical solution, heat dissipation for the central processing unit can be improved, to ensure normal operation of the central processing unit.

According to a third aspect according to the invention, the invention provides an electronic device, including a housing and the heat dissipation module in the second aspect, where the heat dissipation module is disposed in the housing.

Beneficial effects of the electronic device are the same as those of the heat dissipation module in the second aspect, and details are not described herein again.

According to a fourth aspect, where the fourth aspect and any of its implementations and options below are not claimed, a not claimed embodiment of this disclosure provides a method for manufacturing a thermal pad, including the following steps: providing a thermal pad, where the thermal pad includes a pad body, and the pad body includes, in a thickness direction of the pad body, two pad surfaces that are disposed facing away from each other; disposing a hollowed-out part on the pad surface, where a depth of the hollowed-out part is less than a thickness of the pad body; and filling a liquid metal material into the hollowed-out part, to form a liquid metal material layer.

Beneficial effects of the method for manufacturing the thermal pad are the same as those of the thermal pad in the first aspect, and details are not described herein again.

In some not claimed embodiments, after the filling a liquid metal material into the hollowed-out part, the method further includes the following step: attaching a protective film to the pad surface, to cover the liquid metal material layer.

By using the technical solution, leakage of the liquid metal material in the hollowed-out part may be prevented, thereby facilitating storage and transportation of the thermal pad.

In some not claimed embodiments, before the filling a liquid metal material into the hollowed-out part, the method further includes the following step: disposing an anti-spill groove on a periphery of the hollowed-out part.

By using the technical solution, diffusion of the liquid metal material may be prevented, thereby reducing a probability that the liquid metal material leaks out of an edge of the thermal pad.

According to a fifth aspect, where the fifth aspect and any of its implementations and options below are not claimed, a not claimed embodiment of this disclosure provides a method for manufacturing a thermal pad, including the following steps: providing a thermal pad, where the thermal pad includes a pad body, and the pad body includes, in a thickness direction of the pad body, a first pad surface and a second pad surface that are disposed facing away from each other; disposing a hollowed-out part on the pad body, where the hollowed-out part penetrates through the pad body in a thickness direction of the pad body; attaching a protective film to the first pad surface, to cover the hollowed-out part; filling a liquid metal material into the hollowed-out part from an opening of the hollowed-out part on the second pad surface, to form a liquid metal material layer; and attaching a protective film to the second pad surface, to cover the liquid metal material layer.

Beneficial effects of the method for manufacturing the thermal pad are the same as those of the thermal pad in the first aspect, and details are not described herein again.

In some not claimed embodiments, before the filling a liquid metal material into the hollowed-out part, the method further includes the following step: disposing an anti-spill groove on a periphery of the hollowed-out part.

By using the technical solution, diffusion of the liquid metal material may be prevented, thereby reducing a probability that the liquid metal material leaks out of an edge of the thermal pad.

In the following description, features which in the above summary of the invention have been marked as "not claimed" or "according to the invention" are also hereinafter, when they are described and explained with reference to the drawings, to be understood as "not claimed" or "not part of the invention" or "according to the invention". Even if sometimes in the description of the embodiments below, features marked above "according to the invention" or "the invention" are referred to in connection with the words "can" or "may" or other expressions which contain the notion of them being "optional", it should be understood that indeed such features are considered essential to the invention as claimed and not optional.

### BRIEF DESCRIPTION OF DRAWINGS

FIG. 1a is a schematic diagram of a heat dissipation module in a conventional electronic device;
FIG. 1b is a schematic diagram of a heat dissipation module in an electronic device in a related technology;
FIG. 1c is a schematic diagram of a structure of a notebook computer according to some embodiments of this application;
FIG. 2 is a schematic diagram of arrangement of a heat dissipation module according to some embodiments of this application;
FIG. 3 is a schematic diagram of a structure of the heat dissipation module in FIG. 2;
FIG. 4 is a top view of a pad body of a thermal pad according to some embodiments of this application;
FIG. 5 is a sectional view of the pad body in a direction A-A in FIG. 4;
FIG. 6 is a schematic diagram of a structure of a pad body of a thermal pad according to some other embodiments of this application;
FIG. 7 is a schematic diagram of a structure of a thermal pad in FIG. 5 when not being used;
FIG. 8a is a process diagram of manufacturing the thermal pad shown in FIG. 7;
FIG. 8b is a flowchart of a method for manufacturing the thermal pad shown in FIG. 7;
FIG. 9 is a top view of a pad body of a thermal pad according to some other embodiments of this application;
FIG. 10 is a sectional view of the pad body that is in a direction B-B and that is of the thermal pad in FIG. 9;
FIG. 11 is a top view of a pad body of a thermal pad according to some other embodiments of this application;
FIG. 12 is a sectional view of the pad body that is in a direction C-C and that is of the thermal pad in FIG. 11;
FIG. 13 is a schematic diagram of a structure of a protective film attached to the thermal pad in FIG. 12;
FIG. 14a is a process diagram of manufacturing the thermal pad shown in FIG. 13;
FIG. 14b is a flowchart of a method for manufacturing the thermal pad shown in FIG. 13;
FIG. 15 is a top view of a pad body of a thermal pad according to some other embodiments of this application; and
FIG. 16 is a sectional view of the pad body that is in a direction D-D and that is of the thermal pad in FIG. 15.

### DESCRIPTION OF EMBODIMENTS

In embodiments of this application, the terms "first" and "second" are used for descriptive purposes only, and cannot be construed as indicating or implying relative importance or implicitly indicating the quantity of technical features indicated. Therefore, the features defined with "first" and "second" may explicitly or implicitly include one or more of the features.

In embodiments of this application, it should be noted that the term "electrical connection" should be understood in a broad sense, for example, as a direct connection for current conduction or as a capacitive coupling for electric energy conduction.

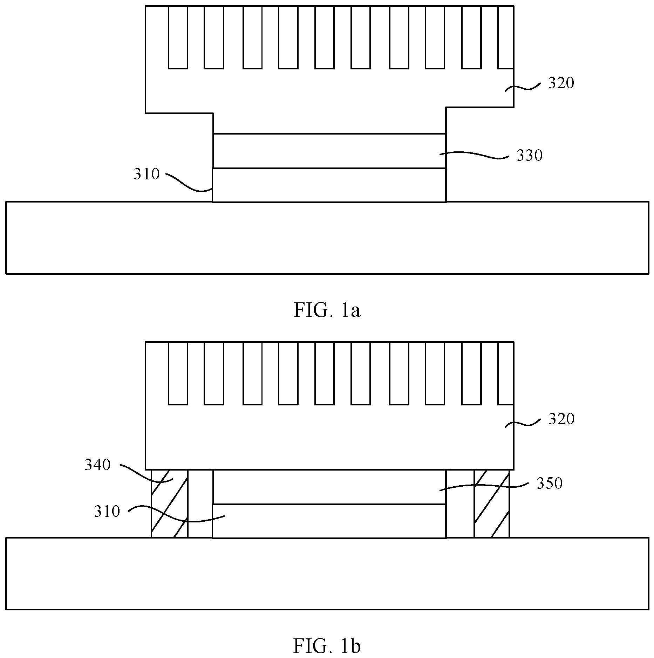

FIG. 1a is a schematic diagram of a heat dissipation module in a conventional electronic device. The heat dissipation module includes an electronic component 310, a heat sink 320, and a thermal pad 330. The thermal pad 330 is disposed between the electronic component 310 and the heat sink 320, to transfer heat generated by the electronic component 310 to the heat sink 320 for dissipation. The thermal pad 330 is usually made of a material such as thermally conductive silicone or thermally conductive silicone rubber. However, heat dissipation efficiency of the thermal pad 330 that is made of the thermally conductive silicone or the thermally conductive silicone rubber is usually 3~15 W·m⁻¹k⁻¹, and the heat dissipation efficiency is relatively low. In this way, the thermal pad 330 cannot dissipate, in a timely manner, the heat generated by the electronic component 310, which cannot meet a heat dissipation requirement of the electronic component 310 (especially the electronic component 310 with high power) in operation.

To improve the heat dissipation efficiency of the electronic component 310, FIG. 1b is a schematic diagram of a heat dissipation module in an electronic device in a related technology. The heat dissipation module includes an electronic component 310, a heat sink 320, and a liquid metal layer 350 that is disposed between the electronic component 310 and the heat sink 320. A material of the liquid metal layer 350 is a liquid metal material (the liquid metal material may be briefly referred to as "liquid metal"). To prevent the liquid metal layer 350 from spilling between the electronic component 310 and the heat sink 320, a sealing structure 340 is further disposed on a periphery of the liquid metal layer 350.

In the heat dissipation structure shown in FIG. 1b, the heat dissipation efficiency of the electronic component 310 can be improved by using the liquid metal layer 350. However, to prevent the liquid metal layer 350 from spilling between the electronic component 310 and the heat sink 320, the sealing structure 340 (that is, a sealing ring) needs to be disposed in the heat dissipation module. After the sealing structure 340 is disposed, the heat dissipation module is more complex, and then a difficulty of assembly process of the heat dissipation module is increased, which increases manufacturing costs of the heat dissipation module.

In addition, a price of the liquid metal material is relatively high. Therefore, if an entire liquid metal layer 350 needs to be disposed between the electronic component 310 and the heat sink 320, a large quantity of liquid metal materials are needed, which increases costs of the heat dissipation module.

It can be learned that the heat dissipation module in the electronic device in the related technology cannot simultaneously improve the heat dissipation efficiency and reduce the manufacturing costs.

Therefore, embodiments of this application provide a thermal pad, a heat dissipation module, and an electronic device. A liquid metal material layer is filled in a hollowed-out part of a pad body of the thermal pad, heat dissipation of the electronic component is more sufficient, and heat dissipation efficiency of the electronic component is improved; in addition, a structure of the heat dissipation module is simplified, and manufacturing costs of the heat dissipation module are reduced.

The electronic device in this embodiment of this application may be a device including a heat dissipation module, such as a notebook computer, a desktop computer, a frequency converter, a solid-state relay, a bridge rectifier, a power battery, an LED (Light-Emitting Diode; light emitting diode) lamp with relatively high power.

The following uses a notebook computer as an example to describe a structure of an internal heat dissipation module in detail. For another electronic device, reference may be made to a structure of the heat dissipation module in this embodiment of the notebook computer, and details are not described herein again.

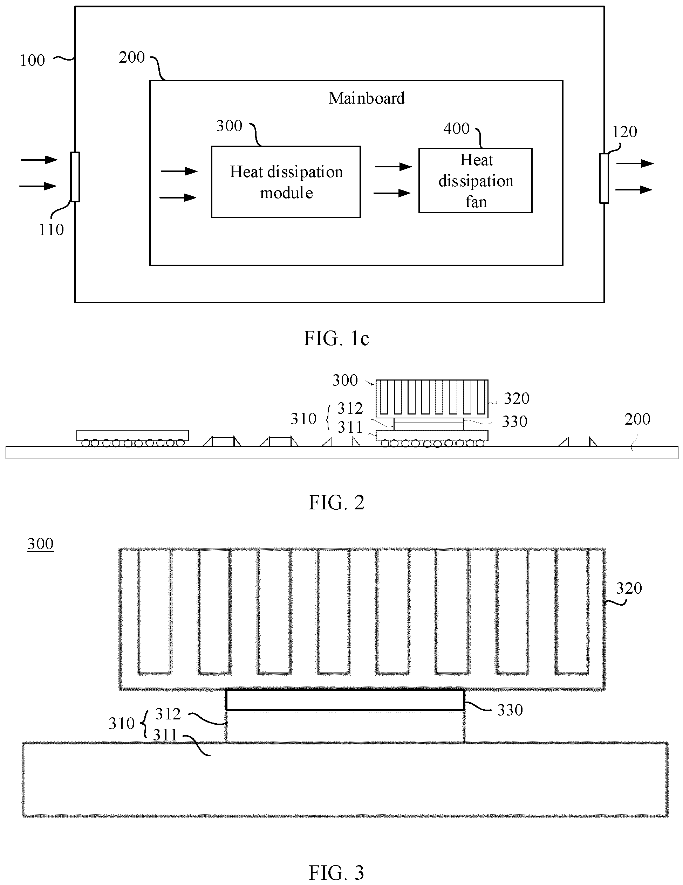

FIG. 1c is a schematic diagram of a structure of a notebook computer according to some embodiments of this application, FIG. 2 is a schematic diagram of arrangement of a heat dissipation module 300 according to some embodiments of this application, and FIG. 3 is a schematic diagram of a structure of the heat dissipation module 300 in FIG. 2. FIG. 2 and FIG. 3 merely show composition of the heat dissipation module 300 and connection relationships between components, not shown according to an actual proportion of each component in an actual product.

The notebook computer includes a housing 100, and a mainboard 200, a heat dissipation module 300, and a heat dissipation fan 400 that are disposed in the housing 100. The housing 100 is provided with an air inlet 110 and an air outlet 120, and both the heat dissipation module 300 and the heat dissipation fan 400 are disposed on the mainboard 200.

The heat dissipation module 300 includes an electronic component 310, a heat sink 320, and a thermal pad 330. The electronic component 310 is a central processing unit (Central Processing Unit; CPU for short), and the central processing unit includes a substrate 311 and a bare die (DIE) 312 disposed on the substrate 311.

Certainly, in addition to being a central processing unit, the electronic component 310 may also be a heat emission component such as a power module, which may be specifically determined based on a type of the electronic device.

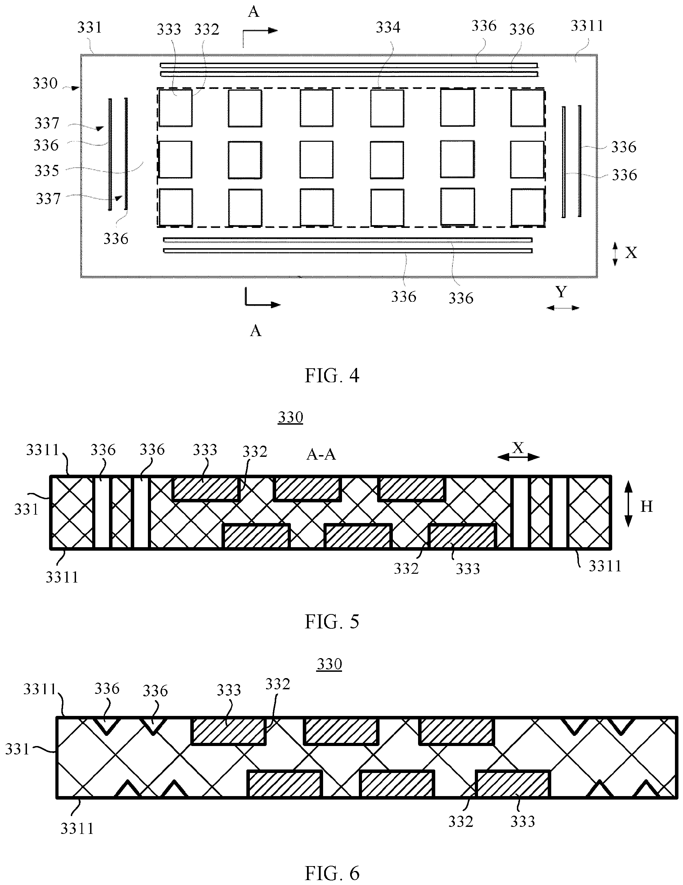

FIG. 4 is a top view of a pad body 331 of a thermal pad 330 according to some embodiments of this application, and FIG. 5 is a sectional view of the pad body 331 in a direction A-A in FIG. 4. The thermal pad 330 includes a pad body 331, a hollowed-out part 332 is disposed on the pad body 331, the hollowed-out part 332 is filled with a liquid metal material layer 333, and the pad body 331 is disposed between the bare die 312 and the heat sink 320.

A liquid metal material is a general term for metal materials that are in a liquid state at a relatively low temperature. The liquid metal material has extremely strong thermal conductivity of a metal material, and heat dissipation efficiency of the liquid metal material is 40~80 W·m⁻¹K⁻¹; in addition, the liquid metal material has a specific fluidity. The liquid metal material may be a low melting point metal, for example, gallium (Ga) or an alkali metal such as sodium (Na), potassium (K), and lithium (Li). The liquid metal material may also be a low melting point alloy, for example, a gallium metal alloy.

The pad body 331 may be made of a thermally conductive material such as thermally conductive silicone, thermally conductive silicone rubber, or graphite.

In operation, the thermal pad 330 conducts heat generated by the bare die 312 to the heat sink 320, and the heat dissipation fan 400 sucks air outside the housing 100 into the housing 100 through the air inlet 110, and then takes away heat emitted from the heat sink 320 when the wind flows through the heat sink 320, and the heat is discharged out of the housing 100 through the air outlet 120. The hollowed-out part 332 of the pad body 331 is filled with a liquid metal material layer 333 with relatively good thermal conductivity. This improves an overall coefficient of thermal conductivity of the thermal pad 330, and reduces overall thermal resistance of the thermal pad 330, so that heat dissipation efficiency of an electronic component 310 is improved, and heat dissipation of the electronic component 310 is more sufficient.

In addition, the liquid metal material layer 333 is filled in the hollowed-out part 332 of the pad body 331, so that the hollowed-out part 332 may limit the flow of the liquid metal material layer 333, and then the pad body 331 can seal the liquid metal material layer 333. Therefore, there is no need to dispose another sealing structure to limit the flow of the liquid metal material layer 333, so that not only a structure of the heat dissipation module 300 is simpler, but also assembly process of the heat dissipation module 300 is simplified, which reduces manufacturing costs of the heat dissipation module 300.

In addition, compared with a full layer of a liquid metal material layer (as shown in FIG. 1b) that is disposed between the electronic component 310 and the heat sink 320, in this embodiment of this application, a liquid metal material layer 333 at a relatively high price is filled in a pad body 331 of a thermal pad 330 at a relatively low price, excessive use of the liquid metal material can be avoided, which meets a heat dissipation requirement of the electronic component 310 and reduces heat dissipation costs of the electronic component 310.

In some embodiments, as shown in FIG. 5, in a thickness direction H of the pad body 331, the pad body 331 includes two pad surfaces 3311 disposed facing away from each other, and the hollowed-out part 332 is disposed on the pad surface 3311. In this way, the hollowed-out part 332 can be easily filled with the liquid metal material layer 333, and the liquid metal material layer 333 in the hollowed-out part 332 can also be in contact with the electronic component 310 or the heat sink 320, thereby greatly reducing overall thermal resistance of the thermal pad 330, and improving a heat dissipation effect of the electronic component 310.

In some embodiments, as shown in FIG. 4 and FIG. 5, a plurality of hollowed-out parts 332 arranged in an array are disposed on the pad surface 3311 of the pad body 331, and the hollowed-out parts 332 are arranged in an array of 6 (columns) × 3 (rows) in FIG. 5. With this arrangement, a coverage area of the hollowed-out part 332 on the pad body 331 of the thermal pad 330 can be increased, so that a coverage area of the liquid metal material layer 333 in the pad body 331 is increased, and then a high-efficiency heat conduction area (that is, a coverage area of the liquid metal material layer 333 in the pad body 331) of the thermal pad 330 is larger, which further improves a heat dissipation effect of the electronic component 310.

In some embodiments, as shown in FIG. 5, each pad surface 3311 of the pad body 331 is provided with a hollowed-out part 332, and a depth of the hollowed-out part 332 is less than a thickness of the pad body 331, that is, the hollowed-out part 332 does not penetrate through the pad body 331. The depth of the hollowed-out part 332 is less than the thickness of the pad body 331, so that the hollowed-out part 332 is equivalent to a "container" of the liquid metal material layer 333, and then the liquid metal material layer 333 can be filled into the hollowed-out part 332 more easily. In addition, each pad surface 3311 of the pad body 331 is provided with a hollowed-out part 332. In this way, the liquid metal material layer 333 in the hollowed-out part 332 of the two pad surfaces 3311 may be separately in contact with the electronic component 310 and the heat sink 320, thereby further reducing the overall thermal resistance of the thermal pad 330, and further improving the heat dissipation effect of the electronic component 310.

In some embodiments, as shown in FIG. 5, the hollowed-out parts 332 disposed on the two pad surfaces 3311 are staggered in a direction Y perpendicular to the thickness direction of the pad body 331. In this way, when a total quantity of hollowed-out parts 332 is specified, a coverage area of the hollowed-out parts 332 on the pad body 331 of the thermal pad 330 can be increased, so that a coverage area of the liquid metal material layer 333 on the pad body 331 can be increased, and then a high-efficiency heat conduction area of the thermal pad 330 is larger, which further improves the heat dissipation effect of the electronic component 310.

For example, as shown in FIG. 4 and FIG. 5, a contour of the pad body 331 is rectangular, and the hollowed-out parts 332 disposed on the two sides of the pad body 331 are staggered in both the width direction X and the length direction Y of the pad body 331.

The hollowed-out part 332 disposed on the two pad surfaces 3311 may be completely staggered, as shown in FIG. 5, or may be partially staggered. "Completely staggered" means that, in the direction perpendicular to the thickness direction of the pad body 331, orthographic projections of the hollowed-out parts 332 of the two pad surfaces 3311 on a first plane do not overlap; and "partially staggered" means that, in the direction Y perpendicular to the thickness direction of the pad body 331, orthographic projections of the hollowed-out parts 332 of the two pad surfaces 3311 on the first plane partially overlap. The first plane is a plane perpendicular to the thickness direction of the pad body 331.

In some embodiments, as shown in FIG. 4 and FIG. 5, the hollowed-out part 332 is a groove. The hollowed-out part 332 is set to be the groove, so that the hollowed-out part 332 may be formed by using a stamping process, to facilitate manufacturing of the hollowed-out part 332.

Certainly, the hollowed-out part 332 may be a hole in addition to the groove, and the hole may also be formed by using the stamping process, to facilitate manufacturing of the hollowed-out part 332.

The hollowed-out part 332 may be disposed in addition to the pad surface 3311 of the pad body 331, or may be disposed inside the pad body 331, and the liquid metal material may be injected into the hollowed-out part 332 inside the pad body 331 by using a needle.

In some embodiments, as shown in FIG. 4 and FIG. 5, a pad surface 3311 of the pad body 331 includes a hollowed-out opening area 334 and a surrounding area 335 located on a periphery of the hollowed-out opening area 334. The hollowed-out opening area 334 is provided with a hollowed-out part 332, and the surrounding area 335 is provided with an anti-spill groove 336.

When the pad body 331 that is attached between the heat sink 320 and the electronic component 310 is extruded, the liquid metal material in the hollowed-out part 332 inevitably spills, and diffuses to the surrounding area 335 along a gap between the thermal pad 330 and the heat sink 320 or the electronic component 310. The anti-spill groove 336 is disposed in the surrounding area 335, so that the spilled liquid metal material can be accommodated, thereby preventing the liquid metal material from continuing to diffuse outward, and reducing a probability that the liquid metal material leaks out of an edge of the thermal pad 330.

In some embodiments, as shown in FIG. 4 and FIG. 5, the anti-spill groove 336 is separated from the hollowed-out part 332, that is, the anti-spill groove 336 is separated from the hollowed-out part 332 by a specific distance, and does not communicate with the hollowed-out part 332. With this arrangement, when the liquid metal material is filled into the hollowed-out part 332, a probability that the liquid metal material in the hollowed-out part 332 enters the anti-spill groove 336 can be reduced.

In some embodiments, as shown in FIG. 4, the anti-spill groove 336 extends in a circumferential direction of the hollowed-out opening area 334. With this arrangement, when the liquid metal material of the hollowed-out part 332 spills and diffuses to a surrounding area 335, the liquid metal material may enter the anti-spill groove 336 more easily, thereby improving an effect of preventing diffusion of the spilled liquid metal material to the surrounding area 335 by the anti-spill groove 336.

For example, as shown in FIG. 4, the hollowed-out opening area 334 is rectangular, and the anti-spill groove 336 extends in a length direction Y or a width direction X of the hollowed-out opening area 334.

In some embodiments, as shown in FIG. 4, the surrounding area 335 is provided with an anti-spill groove group 337, and the anti-spill groove group 337 includes a plurality of anti-spill grooves 336 disposed around the hollowed-out opening area 334. With this arrangement, the plurality of anti-spill grooves 336 disposed around the hollowed-out opening area 334 in the anti-spill groove group 337 can prevent the spilled liquid metal material from diffusing in a plurality of directions, thereby further reducing the probability that the liquid metal material leaks out of the edge of the thermal pad 330.

For example, as shown in FIG. 4, the anti-spill groove group 337 includes four anti-spill grooves 336; and the two anti-spill grooves 336 are separately located on two sides that are of the hollowed-out opening area 334 and that are in a width direction X of the hollowed-out opening area 334, and the other two anti-spill grooves 336 are separately located on two sides that are of the hollowed-out opening area 334 and that are in a length direction Y of the hollowed-out opening area 334.

In some embodiments, as shown in FIG. 4 and FIG. 5, a surrounding area 335 is provided with a plurality of anti-spill groove groups 337, and the plurality of anti-spill groove groups 337 are arranged in a direction away from the hollowed-out opening area 334. With this arrangement, the plurality of anti-spill groove groups 337 can better prevent the spilled liquid metal material 333 from diffusing in a plurality of directions, thereby greatly reducing a probability that the liquid metal material 333 leaks out of the edge of the thermal pad 330.

As shown in FIG. 4, a quantity of anti-spill groove groups 337 are two, but is not limited thereto, and two or more than anti-spill groove groups 337 may be disposed, which may be specifically determined based on a quantity of liquid metal materials filled in the hollowed-out part 332.

In some embodiments, as shown in FIG. 5, each anti-spill groove 336 in the anti-spill groove group 337 penetrates through the pad body 331. In this way, the volume of the anti-spill groove 336 may be increased, which increases a quantity of liquid metal materials accommodated by the anti-spill groove 336, thereby better preventing the liquid metal material from continuing to diffuse outward, and greatly reducing a probability that the liquid metal material leaks out of the edge of the thermal pad 330.

Certainly, if a small amount of the liquid metal material is spilled, the anti-spill groove 336 may not penetrate through the pad body 331. Specifically, FIG. 6 is a schematic diagram of a structure of a pad body 331 of a thermal pad 330 according to some other embodiments of this application. A groove depth of an anti-spill groove 336 is less than a thickness of the pad body 331. A cross section of the anti-spill groove 336 is a triangle, so that the liquid metal material easily enters the anti-spill groove 336.

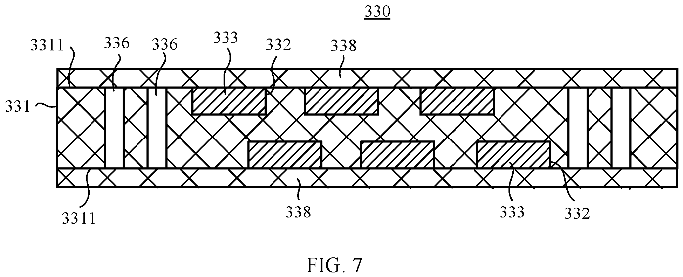

In some embodiments, FIG. 7 is a schematic diagram of a structure of a thermal pad 330 in FIG. 5 when not being used. The thermal pad 330 further includes a protective film 338, and the protective film 338 is attached to the pad surface 3311, to cover the liquid metal material layer 333.

The protective film 338 is disposed, so that when the thermal conductive pad 330 is not used, the protective film 338 can prevent leakage of the liquid metal material in the hollowed-out part 332, thereby facilitating storage and transportation of the thermal conductive pad 330. When the thermal pad 330 is in use, the protective film 338 may be torn off, to ensure that the pad body 331 of the thermal pad 330 is attached between the electronic component 310 and the heat sink 320. An ambient temperature when the pad body 331 is attached may be controlled below a melting point of the liquid metal material. In this way, the liquid metal material layer 333 in the hollowed-out part 332 is solid, so that the pad body 331 can be easily attached.

For example, the protective film 338 may be a PET (polyethylene terephthalate; polyethylene terephthalate) protective film.

If each of the two pad surfaces 3311 of the pad body 331 is provided with the hollowed-out part 332, as shown in FIG. 7, the protective film 338 is attached to the two pad surfaces 3311 of the pad body 331. If one pad surface 3311 of the pad body 331 is provided with the hollowed-out part 332, the protective film 338 may be attached to the pad surface 3311 of the hollowed-out part 332 that is provided with the pad body 331.

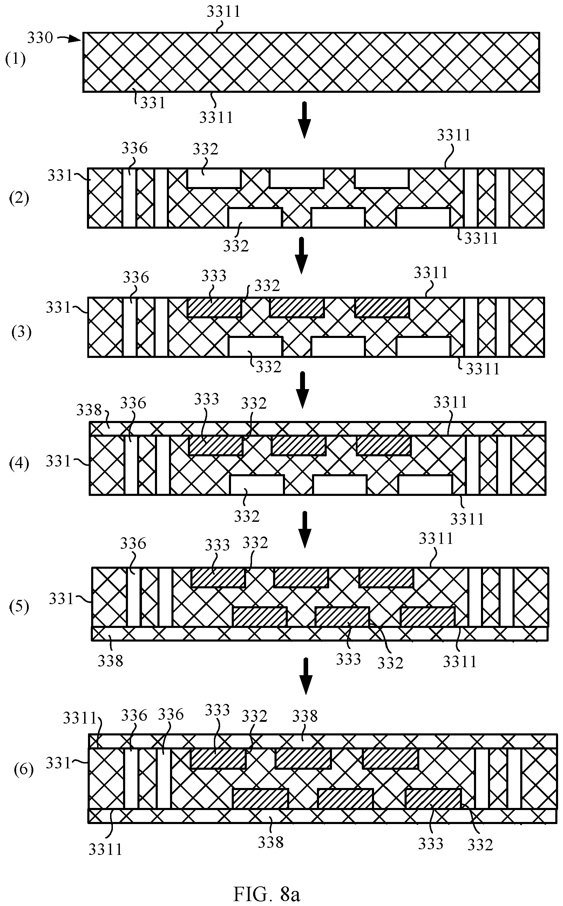

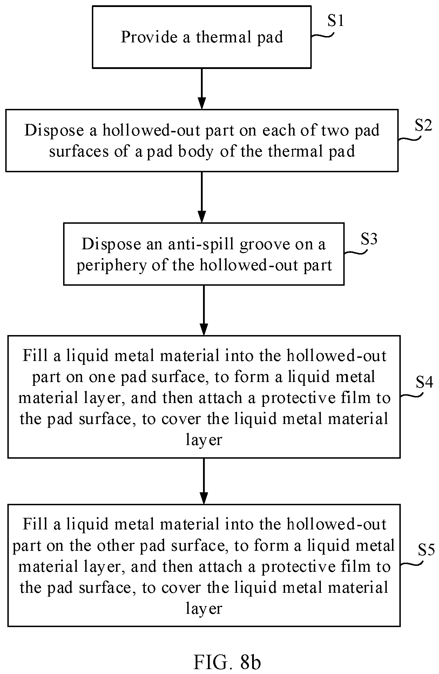

FIG. 8a is a process diagram of manufacturing the thermal pad 330 shown in FIG. 7, and FIG. 8b is a flowchart of a method for manufacturing the thermal pad 330 shown in FIG. 7. A method for manufacturing the thermal pad 330 includes:
S1. As shown (1) in FIG. 8a, provide the thermal pad 330.

The thermal pad 330 includes a pad body 331, and the pad body 331 may be thermally conductive silicone, thermally conductive silicone rubber, graphite, or the like.

S2. As shown (2) in FIG. 8a, dispose a hollowed-out part 332 on each of two pad surfaces 3311 of the pad body 331 of the thermal pad 330.

A depth of the hollowed-out part 332 is less than a thickness of the pad body 331. The hollowed-out part 332 may be formed by using a stamping process, or may be formed by using another process, which is not specifically limited herein.

S3. As shown (2) in FIG. 8a, dispose an anti-spill groove 336 on a periphery of the hollowed-out part 332.

The anti-spill groove 336 may be formed by cutting on the peripheral with a cutter.

S4. As shown (3) and (4) in FIG. 8a, fill a liquid metal material into the hollowed-out part 332 on one pad surface 3311, to form a liquid metal material layer 333, and then attach a protective film 338 to the pad surface 3311, to cover the liquid metal material layer 333.

S5. As shown (5) and (6) in FIG. 8a, fill a liquid metal material into the hollowed-out part 332 on the other pad surface 3311, to form a liquid metal material layer 333, and then attach a protective film 338 to the pad surface 3311, to cover the liquid metal material layer 333.

Certainly, a sequence of S2 and S3 may also be interchanged, that is, the anti-spill groove 336 is first disposed, and then the hollowed-out part 332 is disposed. In addition, the anti-spill groove 336 and the hollowed-out part 332 may be formed on the pad body 331 by using one process, for example, the anti-spill groove 336 and the hollowed-out part 332 are formed on the pad body 331 by using one stamping process.

If another measures is taken to prevent the liquid metal material 333 from leaking out of an edge of the pad body 331, the anti-spill groove 336 may not be disposed.

In step S2, the hollowed-out part 332 may alternatively be disposed on only one pad surface 3311 of the pad body 331. In this way, after the hollowed-out part 332 is filled with a liquid metal material, the protective film 338 is attached to only the pad surface 3311.

In an embodiment in which the hollowed-out part 332 is disposed on only one pad surface 3311 of the pad body 331, if the pad body 331 is stored in an environment below a melting point of the liquid metal material layer 333, the protective film 338 may not be attached to the pad body 331.

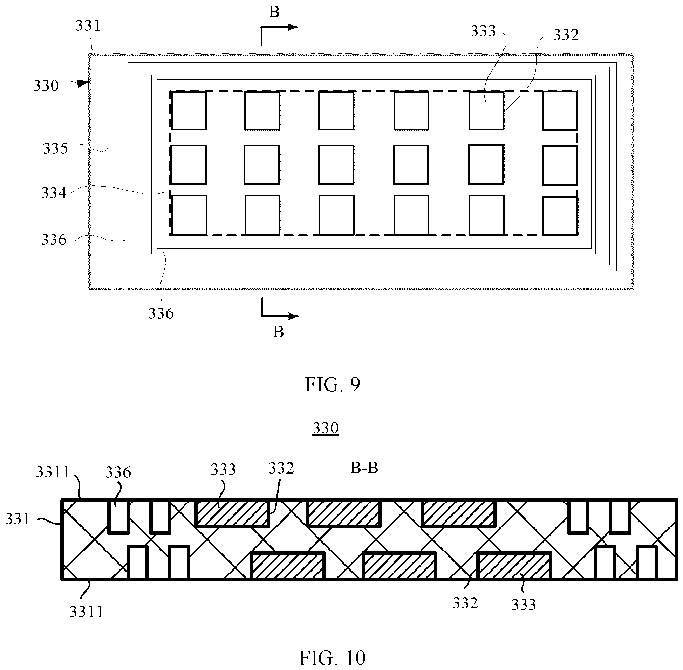

FIG. 9 is a top view of a pad body 331 of a thermal pad 330 according to some other embodiments of this application, and FIG. 10 is a sectional view of the pad body 331 that is in a direction B-B and that is of the thermal pad 330 in FIG. 9. A main difference between the pad body 331 shown in FIG. 9 and FIG. 10 and the pad body 331 shown in FIG. 4 and FIG. 5 is that a shape of the anti-spill groove 336 is different. In this embodiment, the anti-spill groove 336 is a ring groove and is disposed around the hollowed-out opening area 334, and a groove depth of the anti-spill groove 336 is less than a thickness of the pad body 331.

The anti-spill groove 336 is set to be a ring groove, so that the anti-spill groove 336 may enclose the hollowed-out opening area 334, thereby better preventing the spilled liquid metal material from diffusing in a plurality of directions, and reducing a probability that the liquid metal material leaks out of an edge of the thermal pad 330. The groove depth of the anti-spill groove 336 is set to be less than the thickness of the pad body 331, to prevent the ringshaped anti-spill groove 336 from dividing the pad body 331 into two parts.

As shown in FIG. 10, a cross-sectional shape of the anti-spill groove 336 is rectangular, but is not limited thereto. The cross-sectional shape of the anti-spill groove 336 may be another shape, for example, a triangle. The shape of the anti-spill groove 336 may be a rectangular ring, or may be a circular ring, which may be specifically determined based on a shape of the pad body 331 and the hollowed-out opening area 334.

In some embodiments, as shown in FIG. 9 and FIG. 10, a surrounding area 335 is provided with a plurality of anti-spill grooves 336, and the plurality of anti-spill grooves 336 are arranged in a direction away from the hollowed-out opening area 334. With this arrangement, the plurality of anti-spill grooves 336 can better prevent the spilled liquid metal material from diffusing in a plurality of directions, thereby greatly reducing a probability that the liquid metal material leaks out of the edge of the thermal pad 330.

To prevent leakage of the liquid metal material and facilitate storage and transportation of the thermal pad, the protective film 338 may also be attached to the pad surface 3311 of the pad body 331 shown in FIG. 9 and FIG. 10.

The thermal pad 330 shown in FIG. 9 and FIG. 10 can be manufactured with reference to the method shown in FIG. 8a and FIG. 8b, and details are not described herein again.

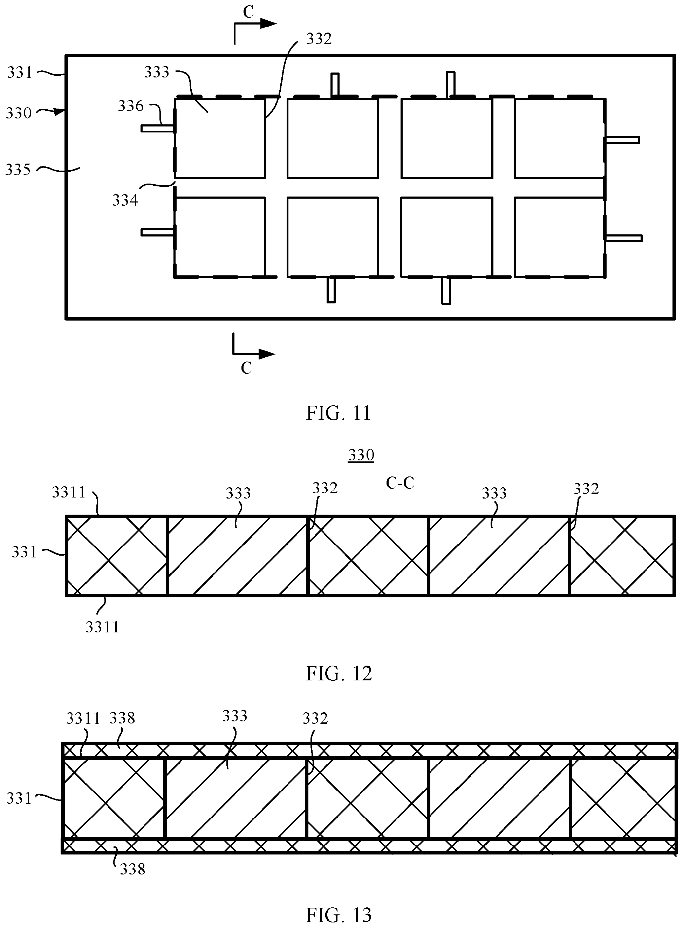

FIG. 11 is a top view of a pad body 331 of a thermal pad 330 according to some other embodiments of this application, and FIG. 12 is a sectional view of the pad body 331 that is in a direction C-C and that is of the thermal pad 330 in FIG. 11. A main difference between the pad body 331 shown in FIG. 11 and FIG. 12 and the pad body 331 shown in FIG. 4 and FIG. 5 is that a structure of the hollowed-out part 332 is different, and a relationship between the anti-spill groove 336 and the hollowed-out part 332 is different.

In this embodiment, the hollowed-out part 332 penetrates through the pad body 331. In this way, a liquid metal material layer 333 in the hollowed-out part 332 may be separately in contact with an electronic component 310 and a heat sink 320, thereby further reducing the overall thermal resistance of the thermal pad 330, and further improving the heat dissipation effect of the electronic component 310.

In this embodiment, one end of the anti-spill groove 336 extends to an edge of the hollowed-out part 332, to communicate with the hollowed-out part 332. In this way, when the pad body 331 that is attached between the heat sink 320 and the electronic component 310 is extruded, the liquid metal material in the hollowed-out part 332 can directly enter the anti-spillage groove 336, thereby greatly reducing a probability that the liquid metal material spills from an edge of the hollowed-out part 332.

A width of the anti-spill groove 336 is an important parameter, and the width of the anti-spill groove 336 should not be too large or too small. If the width of the anti-spill groove 336 is too large, when the liquid metal material is filled into the hollowed-out part 332, a part of the liquid metal material enters the anti-spill groove 336, and occupies a space in the anti-spill groove 336, which affects an anti-spill effect of the anti-spill groove 336 on the liquid metal material. If the width of the anti-spill groove 336 is too small, an accommodating space of the anti-spill groove 336 is smaller, and a quantity of liquid metal materials accommodated are smaller, which also affects the anti-spill effect of the anti-spill groove 336 on the liquid metal material. It is found through research that, when a width range of the anti-spill groove 336 is 0.1~0.2 mm, the liquid metal material filled into the hollowed-out part 332 will not easily enter the anti-spill groove 336, or an accommodating space of the anti-spill groove 336 will not be too small, thereby ensuring that the anti-spill groove 336 can better prevent spilling of the liquid metal material.

In some embodiments, as shown in FIG. 11, a hollowed-out opening area 334 is provided with two rows of hollowed-out parts 332, each row includes a plurality of hollowed-out parts 332 (four hollowed-out parts 332 in each row are shown in the figure), and each hollowed-out part 332 separately communicates with one anti-spill groove 336. Two rows of hollowed-out parts 332 are disposed in the hollowed-out opening area 334. In this way, each hollowed-out part 332 in the two rows is adjacent to the surrounding area 335, so that the anti-spill groove 336 can easily communicate with each hollowed-out part 332.

Certainly, in addition to separately communicating with one anti-spill groove 336, each hollowed-out part 332 may communicate with two or more than two anti-spill grooves 336, which may be specifically determined based on a quantity of liquid metal materials in each hollowed-out part 332.

FIG. 13 is a schematic diagram of a structure of a protective film 338 attached to the thermal pad 330 in FIG. 12. The protective film 338 may be separately attached to each pad surface 3311 of the pad body 331, and the protective film 338 attached to each pad surface 3311 covers the hollowed-out part 332. When the hollowed-out part 332 is filled with the liquid metal material, the protective film 338 may be attached to one pad surface 3311. In this case, the protective film 338 and the hollowed-out part 332 form a "container" for accommodating the liquid metal material, thereby preventing the liquid metal material from leaking out of the other side of the pad body 331 when being filled into the hollowed-out part 332

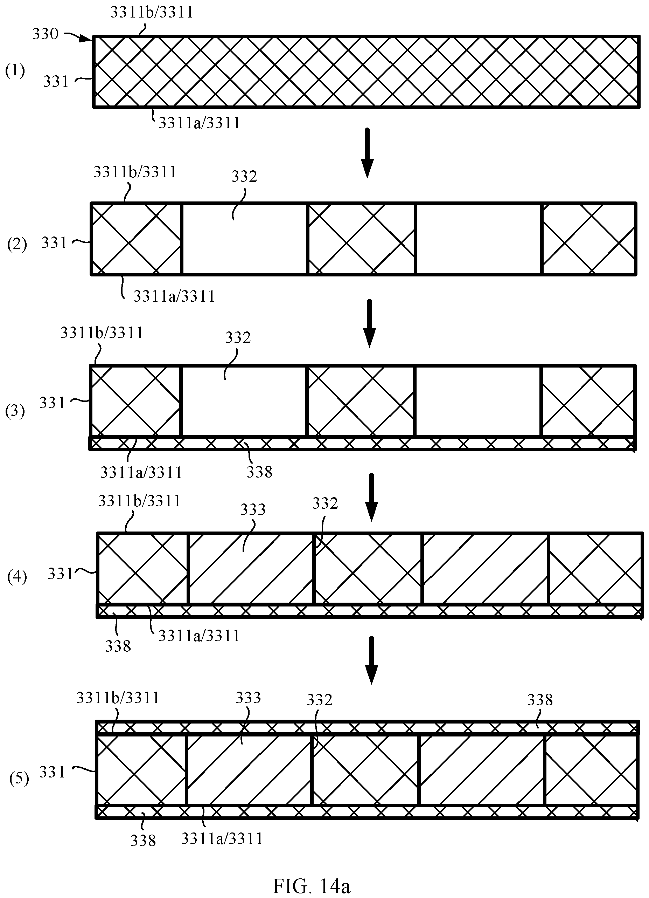

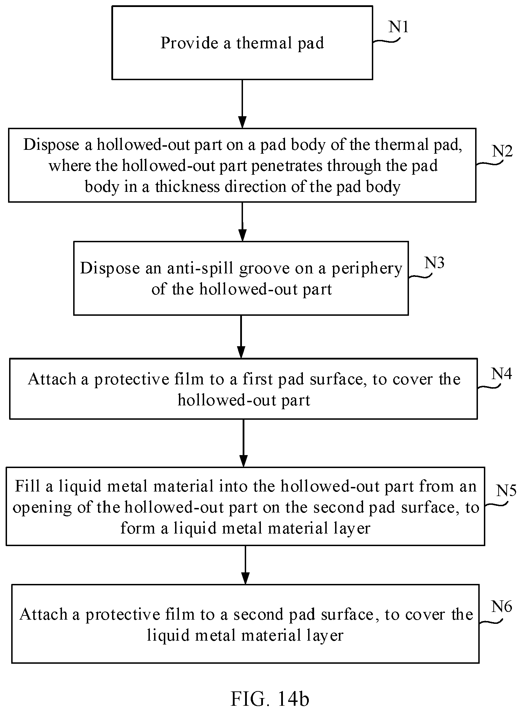

FIG. 14a is a process diagram of manufacturing the thermal pad 330 shown in FIG. 13, and FIG. 14b is a flowchart of a method for manufacturing the thermal pad 330 shown in FIG. 13. A method for manufacturing the thermal pad 330 includes:
N1. As shown (1) in FIG. 14a, provide the thermal pad 330.

The thermal pad 330 includes a pad body 331, and two pad surfaces 3311 of the pad body 331 are a first pad surface 3311a and a second pad surface 3311b.

N2. As shown (2) in FIG. 14a, dispose a hollowed-out part 332 on the pad body 331 of the thermal pad 330.

The hollowed-out part 332 penetrates through the pad body 331 in a thickness direction of the pad body 331.

N3. Dispose an anti-spill groove 336 on a periphery of the hollowed-out part 332.

N4. As shown (3) in FIG. 14a, attach a protective film 338 to the first pad surface 3311a, to cover the hollowed-out part 332.

N5. As shown (4) in FIG. 14a, fill a liquid metal material into the hollowed-out part 332 from an opening of the hollowed-out part 332 on the second pad surface 3311b, to form a liquid metal material layer 333.

N6. As shown (5) in FIG. 14a, attach the protective film 338 to the second pad surface 3311b, to cover the liquid metal material layer 333.

Certainly, a sequence of N2 and N3 may also be interchanged, that is, the anti-spill groove 336 is first disposed, and then the hollowed-out part 332 is disposed. In addition, the anti-spill groove 336 and the hollowed-out part 332 may be formed on the pad body 331 by using one process, for example, the anti-spill groove 336 and the hollowed-out part 332 are formed on the pad body 331 by using one stamping process. If another measure is taken to prevent the liquid metal material from spilling from an edge of the hollowed-out part 332, the anti-spill groove 336 may not be disposed.

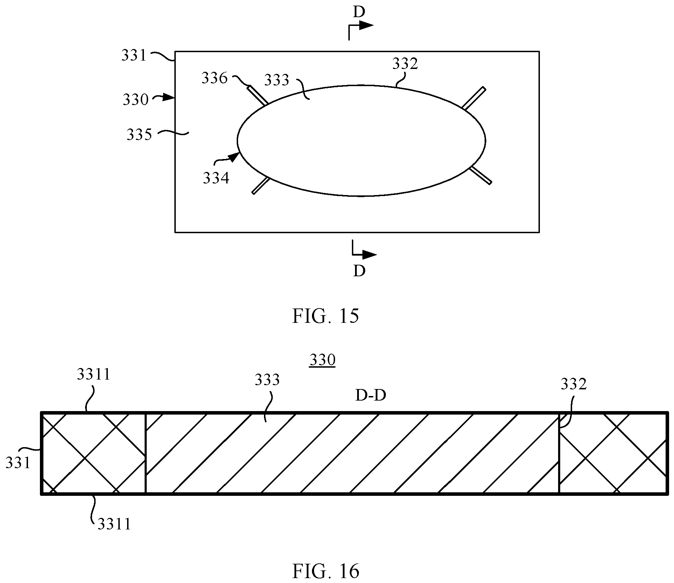

FIG. 15 is a top view of a pad body 331 of a thermal pad 330 according to some other embodiments of this application, and FIG. 16 is a sectional view of the pad body 331 that is in a direction D-D and that is of the thermal pad 330 in FIG. 15. A main difference between the pad body 331 shown in FIG. 15 and FIG. 16 and the pad body 331 shown in FIG. 11 and FIG. 12 is that a quantity of hollowed-out parts 332 disposed in the hollowed-out opening area 334 is different.

In this embodiment, the hollowed-out opening area 334 is provided with a hollowed-out part 332. A contour shape of the hollowed-out part 332 is elliptical, but is not limited thereto. The contour shape of the hollowed-out part 332 may also be circular, rectangular, or the like, which may be specifically determined based on an actual situation.

For a specific setting manner of an anti-spill groove 336 in this embodiment, reference may be made to the setting manners shown in FIG. 11 and FIG. 12, or reference may be made to the setting manners shown in FIG. 4 and FIG. 5, or reference may be made to the setting manners shown in FIG. 9 and FIG. 10, which may be specifically determined based on an actual situation.

To prevent leakage of the liquid metal material and facilitate storage and transportation of the thermal pad, the protective film 338 may also be attached to the pad surface 3311 of the pad body 331 shown in FIG. 15 and FIG. 16.

The thermal pad 330 shown in FIG. 15 and FIG. 16 can be manufactured with reference to the method shown in FIG. 14a and FIG. 14b, and details are not described herein again.

In the description of the specification, specific features, structures, materials or characteristics may be combined in any suitable manner in one or more embodiments or examples.

Finally, it should be noted that the foregoing embodiments are only used to illustrate the technical solutions of embodiments of this application, but are not used to limit this application. Although this application has been described in detail with reference to the foregoing embodiments, it should be understood by a person of ordinary skill in the art that the technical solutions described in the foregoing embodiments may still be modified, or some or all technical features thereof may be equivalently replaced. These modifications or replacements do not make the essence of the corresponding technical solutions depart from the scope of the technical solutions of embodiments of this application.

## Claims

1. A thermal pad (330), comprising a pad body (331), wherein the pad body (331) is provided with a hollowed-out part (332), and the hollowed-out part (332) is filled with a liquid metal material layer (333); wherein
in a thickness direction of the pad body (331), the pad body (331) comprises two pad surfaces (3311, 3311a, 3311b) that are disposed facing away from each other, and the hollowed-out part (332) is disposed on the pad surface (3311, 3311a, 3311b);
the hollowed-out part penetrates through the pad body (331).; and
each pad surface (3311, 3311a, 3311b) is provided with the hollowed-out part (332), and a depth of the hollowed-out part (332) is less than a thickness of the pad body (331).

2. The thermal pad (330) according to claim 1, wherein
the hollowed-out parts (332) disposed on the two pad surfaces (3311, 3311a, 3311b) are staggered in a direction perpendicular to the thickness direction of the pad body (331).

3. The thermal pad (330) according to claim 1, wherein
the pad surface (3311, 3311a, 3311b) comprises a hollowed-out opening area (334) and a surrounding area (335) that is located on a periphery of the hollowed-out opening area (334); and
the hollowed-out opening area (334) is provided with the hollowed-out part (332), and the surrounding area (335) is provided with an anti-spill groove (336).

4. The thermal pad (330) according to claim 3, wherein
the anti-spill groove (336) is separated from the hollowed-out part (332).

5. The thermal pad (330) according to claim 4, wherein
the anti-spill groove (336) extends in a circumferential direction of the hollowed-out opening area (334).

6. The thermal pad (330) according to claim 4 or 5, wherein
the surrounding area (335) is provided with an anti-spill groove group (337), and the anti-spill groove group (337) comprises a plurality of anti-spill grooves (336) disposed around the hollowed-out opening area (334).

7. The thermal pad (330) according to claim 6, wherein
the surrounding area (335) is provided with the plurality of anti-spill groove groups (337), and the plurality of anti-spill groove groups (337) are arranged in a direction away from the hollowed-out opening area (334).

8. The thermal pad (330) according to claim 6 or 7, wherein
each anti-spill groove (336) in the anti-spill groove groups penetrates through the pad body (331).

9. The thermal pad (330) according to claim 4, wherein
the anti-spill groove (336) is a ring groove and is disposed around the hollowed-out opening area (334), and a groove depth of the anti-spill groove (336) is less than the thickness of the pad body (331).

10. The thermal pad (330) according to claim 9, wherein
the surrounding area (335) is provided with the plurality of anti-spill grooves (336), and the plurality of anti-spill grooves (336) are arranged in a direction away from the hollowed-out opening area (334).

11. The thermal pad (330) according to claim 3, wherein
one end of the anti-spill groove (336) extends to an edge of the hollowed-out part (332), to communicate with the hollowed-out part (332).

12. The thermal pad (330) according to claim 11, wherein
the hollowed-out opening area (334) is provided with two rows of the hollowed-out parts (332), each row comprises a plurality of hollowed-out parts (332), and each hollowed-out part (332) separately communicates with at least one anti-spill groove (336).

13. A heat dissipation module (300), comprising:
an electronic component (310);
a heat sink (320); and
the thermal pad (330) according to any one of claims 1~12 wherein a pad body (331) of the thermal pad (330) is disposed between the electronic component (310) and the heat sink (320);
the electronic component (310) is a central processing unit; and the central processing unit comprises a substrate (311) and a bare die (312) disposed on the substrate (311), and the pad body (331) is disposed between the bare die (312) and the heat sink (320).

14. An electronic device, comprising:
a housing (100); and
the heat dissipation module (300) according to claim 13, wherein the heat dissipation module (300) is disposed in the housing (100).

## Patentansprüche

1. Ein Wärmeleitpad (330), umfassend einen Padkörper (331), wobei der Padkörper (331) mit einem hohlen Teil (332) versehen ist, und der hohle Teil (332) mit einer Flüssigmetallmaterialschicht (333) gefüllt ist; wobei
in einer Dickrichtung des Padkörpers (331) der Padkörper (331) zwei Padoberflächen (3311, 3311a, 3311b) umfasst, die einander abgewandt angeordnet sind, und der hohle Teil (332) auf der Padoberfläche (3311, 3311a, 3311b) angeordnet ist;
der hohle Teil durchdringt den Padkörper (331); und
jede Padoberfläche (3311, 3311a, 3311b) ist mit dem hohlen Teil (332) versehen, und eine Tiefe des hohlen Teils (332) ist geringer als eine Dicke des Padkörpers (331).

2. Das Wärmeleitpad (330) nach Anspruch 1, wobei
die auf den beiden Padoberflächen (3311, 3311a, 3311b) angeordneten hohlen Teile (332) in einer Richtung senkrecht zur Dickrichtung des Padkörpers (331) versetzt sind.

3. Das Wärmeleitpad (330) nach Anspruch 1, wobei
die Padoberfläche (3311, 3311a, 3311b) einen hohlen Öffnungsbereich (334) und einen umgebenden Bereich (335) umfasst, der sich am Rand des hohlen Öffnungsbereichs (334) befindet; und
der hohle Öffnungsbereich (334) mit dem hohlen Teil (332) versehen ist, und der umgebende Bereich (335) mit einer Anti-Verschüttungsnut (336) versehen ist.

4. Das Wärmeleitpad (330) nach Anspruch 3, wobei
die Anti-Verschüttungsnut (336) vom hohlen Teil (332) getrennt ist.

5. Das Wärmeleitpad (330) nach Anspruch 4, wobei
die Anti-Verschüttungsnut (336) sich in einer Umfangsrichtung des hohlen Öffnungsbereichs (334) erstreckt.

6. Das Wärmeleitpad (330) nach Anspruch 4 oder 5, wobei
der umgebende Bereich (335) mit einer Gruppe von Anti-Verschüttungsnuten (337) versehen ist, und die Gruppe von Anti-Verschüttungsnuten (337) umfasst mehrere Anti-Verschüttungsnuten (336), die um den hohlen Öffnungsbereich (334) angeordnet sind.

7. Das Wärmeleitpad (330) nach Anspruch 6, wobei
der umgebende Bereich (335) mit mehreren Gruppen von Anti-Verschüttungsnuten (337) versehen ist, und die mehreren Gruppen von Anti-Verschüttungsnuten (337) in einer Richtung vom hohlen Öffnungsbereich (334) weg angeordnet sind.

8. Das Wärmeleitpad (330) nach Anspruch 6 oder 7, wobei
jede Anti-Verschüttungsnut (336) in den Gruppen von Anti-Verschüttungsnuten den Padkörper (331) durchdringt.

9. Das Wärmeleitpad (330) nach Anspruch 4, wobei
Die Anti-Verschüttungsnut (336) ist eine Ringnut und befindet sich um den ausgehöhlten Öffnungsbereich (334), wobei die Nutentiefe der Anti-Verschüttungsnut (336) geringer ist als die Dicke des Polsterkörpers (331).

10. Das Wärmeleitpad (330) gemäß Anspruch 9, wobei
Der umliegende Bereich (335) ist mit einer Vielzahl von Anti-Verschüttungsnuten (336) versehen, die in einer Richtung weg vom ausgehöhlten Öffnungsbereich (334) angeordnet sind.

11. Das Wärmeleitpad (330) gemäß Anspruch 3, wobei
Ein Ende der Anti-Verschüttungsnut (336) erstreckt sich bis zu einem Rand des ausgehöhlten Teils (332), um mit dem ausgehöhlten Teil (332) zu kommunizieren.

12. Das Wärmeleitpad (330) gemäß Anspruch 11, wobei
Der ausgehöhlte Öffnungsbereich (334) ist mit zwei Reihen von ausgehöhlten Teilen (332) versehen, wobei jede Reihe eine Vielzahl von ausgehöhlten Teilen (332) umfasst und jedes ausgehöhlte Teil (332) separat mit mindestens einer Anti-Verschüttungsnut (336) kommuniziert.

13. Ein Wärmeableitungsmodul (300), umfassend:
Eine elektronische Komponente (310);
Einen Kühlkörper (320); und
Das Wärmeleitpad (330) gemäß einem der Ansprüche 1~12, wobei ein Polsterkörper (331) des Wärmeleitpads (330) zwischen der elektronischen Komponente (310) und dem Kühlkörper (320) angeordnet ist;
Die elektronische Komponente (310) ist eine zentrale Verarbeitungseinheit; und die zentrale Verarbeitungseinheit umfasst ein Substrat (311) und einen blanken Chip (312), der auf dem Substrat (311) angeordnet ist, und der Polsterkörper (331) ist zwischen dem blanken Chip (312) und dem Kühlkörper (320) angeordnet.

14. Ein elektronisches Gerät, umfassend:
Ein Gehäuse (100); und
Das Wärmeableitungsmodul (300) gemäß Anspruch 13, wobei das Wärmeableitungsmodul (300) im Gehäuse (100) angeordnet ist.

## Revendications

1. Un coussin thermique (330), comprenant un corps de coussin (331), où le corps de coussin (331) est doté d'une partie évidée (332), et la partie évidée (332) est remplie d'une couche de matériau métallique liquide (333); où
dans une direction d'épaisseur du corps de coussin (331), le corps de coussin (331) comprend deux surfaces de coussin (3311, 3311a, 3311b) qui sont disposées en s'éloignant l'une de l'autre, et la partie évidée (332) est disposée sur la surface de coussin (3311, 3311a, 3311b);
la partie évidée traverse le corps de coussin (331); et
chaque surface de coussin (3311, 3311a, 3311b) est dotée de la partie évidée (332), et une profondeur de la partie évidée (332) est inférieure à une épaisseur du corps de coussin (331).

2. Le coussin thermique (330) selon la revendication 1, où
les parties évidées (332) disposées sur les deux surfaces de coussin (3311, 3311a, 3311b) sont décalées dans une direction perpendiculaire à la direction d'épaisseur du corps de coussin (331).

3. Le coussin thermique (330) selon la revendication 1, où
la surface de coussin (3311, 3311a, 3311b) comprend une zone d'ouverture évidée (334) et une zone environnante (335) située sur une périphérie de la zone d'ouverture évidée (334); et
la zone d'ouverture évidée (334) est dotée de la partie évidée (332), et la zone environnante (335) est dotée d'une rainure anti-débordement (336).

4. Le coussin thermique (330) selon la revendication 3, où
la rainure anti-débordement (336) est séparée de la partie évidée (332).

5. Le coussin thermique (330) selon la revendication 4, où
la rainure anti-débordement (336) s'étend dans une direction circonférentielle de la zone d'ouverture évidée (334).

6. Le coussin thermique (330) selon la revendication 4 ou 5, où
la zone environnante (335) est dotée d'un groupe de rainures anti-débordement (337), et le groupe de rainures anti-débordement (337) comprend une pluralité de rainures anti-débordement (336) disposées autour de la zone d'ouverture évidée (334).

7. Le coussin thermique (330) selon la revendication 6, où
la zone environnante (335) est dotée de la pluralité de groupes de rainures anti-débordement (337), et la pluralité de groupes de rainures anti-débordement (337) sont disposés dans une direction s'éloignant de la zone d'ouverture évidée (334).

8. Le coussin thermique (330) selon la revendication 6 ou 7, où
chaque rainure anti-débordement (336) dans les groupes de rainures anti-débordement traverse le corps de coussin (331).

9. Le coussin thermique (330) selon la revendication 4, où
la rainure anti-débordement (336) est une rainure annulaire et est disposée autour de la zone d'ouverture évidée (334), et une profondeur de rainure de la rainure anti-débordement (336) est inférieure à l'épaisseur du corps du coussin (331).

10. Le coussin thermique (330) selon la revendication 9, dans lequel
la zone environnante (335) est dotée de plusieurs rainures anti-débordement (336), et les plusieurs rainures anti-débordement (336) sont disposées dans une direction s'éloignant de la zone d'ouverture évidée (334).

11. Le coussin thermique (330) selon la revendication 3, dans lequel
une extrémité de la rainure anti-débordement (336) s'étend jusqu'à un bord de la partie évidée (332), pour communiquer avec la partie évidée (332).

12. Le coussin thermique (330) selon la revendication 11, dans lequel
la zone d'ouverture évidée (334) est dotée de deux rangées de parties évidées (332), chaque rangée comprenant plusieurs parties évidées (332), et chaque partie évidée (332) communique séparément avec au moins une rainure anti-débordement (336).

13. Un module de dissipation thermique (300), comprenant :
un composant électronique (310);
un dissipateur thermique (320); et
le coussin thermique (330) selon l'une quelconque des revendications 1 à 12, dans lequel un corps de coussin (331) du coussin thermique (330) est disposé entre le composant électronique (310) et le dissipateur thermique (320);
le composant électronique (310) est une unité centrale de traitement ; et l'unité centrale de traitement comprend un substrat (311) et une puce nue (312) disposée sur le substrat (311), et le corps de coussin (331) est disposé entre la puce nue (312) et le dissipateur thermique (320).

14. Un dispositif électronique, comprenant:
un boîtier (100) ; et
le module de dissipation thermique (300) selon la revendication 13, dans lequel le module de dissipation thermique (300) est disposé dans le boîtier (100).
